Europäisches Patentamt

(19) European Patent Office

Office européen des brevets

(11) Numéro de publication: **0 028 783**

**A1**

(12) # DEMANDE DE BREVET EUROPEEN

(21) Numéro de dépôt: **80106731.5**

(22) Date de dépôt: **03.11.80**

(51) Int. Cl.³: **H 03 H 9/05**

(30) Priorité: **05.11.79 FR 7927617**

(43) Date de publication de la demande:
**20.05.81 Bulletin 81/20**

(84) Etats Contractants Désignés:
**CH DE GB LI**

(71) Demandeur: **SOCIETE SUISSE POUR L'INDUSTRIE
HORLOGERE MANAGEMENT SERVICES S.A.
Rue Stämpfli 96
CH-2500 Bienne(CH)**

(72) Inventeur: **Voumard, Martial
Chemin du Berghaus, 15
CH-2502 Bienne(CH)**

(74) Mandataire: **Coutts, William Robert
SSIH Management Services S.A. Patent Service Rue
Stämpfli 96
CH-2500 Bienne(CH)**

(54) Procédé de fixation d'un résonateur piézoélectrique sur une embase.

㊸ Les broches conductrices (2) traversant une embase support d'un résonateur piézoélectrique sont pliées (3,4) l'une vers l'autre de manière que l'espace restant libre soit légèrement inférieur à l'épaisseur du diapason (8). Le diapason (8) est ensuite inséré entre les broches (2) où il reste maintenu par pincement. La fixation est achevée par dépôt d'une pâte conductrice ou d'un alliage de soudure. De préférence, la partie pliée (5) des broches (2) est écrasée pour former un épanouissement plan (7) sur lequel va s'appuyer le diapason (8).

Fig.3a. Fig.3b.

Croydon Printing Company Ltd.

EP 0 028 783 A1

## Procédé de fixation d'un résonateur piézoélectrique sur une embase

L'invention est relative à l'assemblage de résonateurs piézoélectriques à diapason.

Divers procédés de fixation d'un diapason sur son embase sont connus et largement utilisés. C'est le cas notamment de celui qui est décrit dans le brevet FR 1 539 922. Dans ce cas par exemple, le diapason est directement scellé sur l'embase support, les connexions avec les parties métallisées du diapason étant assurées par des fils soudés ou encore par un vernis métallisé. L'embase, elle, se présente généralement sous la forme d'un anneau de kovar emprisonnant une perle de verre traversée de façon étanche au vide par deux fils formant broches, par exemple en kovar.

Cette technique bien qu'usuelle présente des inconvénients. En effet, l'espace libre existant entre les broches de l'embase doit être supérieur à l'épaisseur du diapason pour que celui-ci puisse y venir trouver place. Le diapason y prend alors une position quelconque en s'appuyant sur l'une ou l'autre des deux broches. Hormis le fait que le positionnement du diapason n'est pas parfait, si l'on ne fait pas appel à des fils de connexion additionnels, le jeu ainsi laissé doit être rattrapé et comblé par la matière, soit pâte ou vernis conducteur, soit alliage de soudure qui va assurer le contact électrique entre les électrodes métallisées du diapason et les broches.

Dans l'hypothèse d'une pâte ou d'un vernis conducteur, la quantité exacte de matière à rapporter pour réaliser la connexion entre le diapason et la broche peut varier entre un minimum si le diapason est en contact avec la broche considérée et un maximum s'il est en contact avec la broche opposée. Cette variation possible mène en général à un excès ou à un insuffisance de matière selon la conception et le réglage du dispositif applicateur de matière. En cas d'excès, on a un barbouillage de la fixation et en cas d'insuffisance, le contact électrique peut faire défaut. Dans les deux cas, le produit obtenu est impropre à l'utilisation envisagée.

Dans le cas d'utilisation d'alliage de soudure, la broche qui n'est pas en contact avec le diapason rend extrêmement difficiles les échanges thermiques indispensables à une répartition correcte de la matière en fusion. L'alliage qui se présente en général sous forme de fil a ainsi tendance à revêtir soit la broche seule, soit le diapason seul. Il est alors nécessaire de compenser cet effet par un apport d'alliage complémentaire.

La présente invention a pour objet de remédier aux inconvénients qui viennent d'être évoqués en proposant un procédé de fixation du diapason dans lequel les broches sont préalablement préparées de manière que le diapason puisse s'insérer sans jeu dans l'espace les séparant.

Pour l'intelligence de la description qui suit, on se référera aux dessins parmi lesquels :

Les figures 1a et 1b sont des vues respectivement de face et de profil d'une embase prête à la fixation selon la technique antérieure.

Les figures 2a et 2b, les mêmes vues d'une embase dont les broches ont été préparées selon le procédé objet de l'invention.

Les figures 3a et 3b représentent la même embase avec le diapason fixé selon le procédé objet de l'invention.

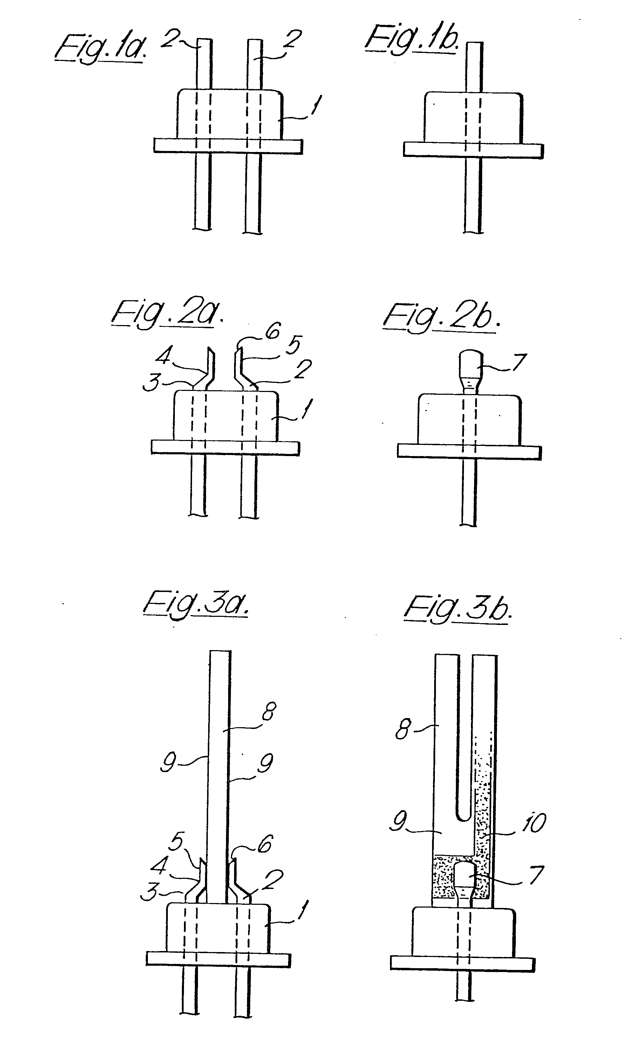

L'état de la technique évoqué plus haut est illustré par les figures 1a et 1b représentant une embase pour diapason piézoélectrique. Cette embase est constituée d'un anneau métallique 1 emprisonnant une perle de verre (non visible au dessin). La perle est traversée par une paire de conducteurs 2 appelés broches, parallèles, de section circulaire et séparés par un espace suffisant pour accueillir entre eux la base du diapason (non représenté). L'ensemble constitue une traversée étanche au vide tout à fait classique.

Selon l'invention, illustrées aux figures 2a, 2b, 3a et 3b, les broches 2, fabriquées dans un matériau conducteur déformable tel par exemple que le kovar, sont pliées en 3 et 4 au moyen d'un outillage de précision approprié de manière à obtenir un rapprochement des zones d'extrémité 5 des deux broches 2 l'une par rapport à l'autre, et ce, en ménageant une réouverture à l'extrémité 6 elle-même. Le rapprochement obtenu est tel que l'espace restant libre entre les zones d'extrémité 5 après pliage soit très légèrement inférieur à l'épaisseur du diapason 8 pour que celui-ci puisse être maintenu entre ces zones 5 par simple pincement élastique, et la réouverture 6 telle que l'espace à ce niveau soit très légèrement supérieur à cette épaisseur pour faciliter l'insertion du diapason 8. De préférence, les zones d'extrémité 5 des broches 2 sont en outre déformées par écrasement de leur section circulaire de manière à former un épanouissement plan 7. De la sorte, le diapason 8 prendra appui par ses grandes faces 9 sur les épanouissements 7. Il pourra donc être parfaitement positionné en appui par sa base sur la surface supérieure de l'embase 1 et par ses deux grandes faces 9 sur les épanouissements 7 entre lesquels il sera maintenu légèrement pincé. L'insertion et le positionnement du diapason 8 constituent donc une opération particulièrement aisée.

L'apport de matière conductrice, pâte ou vernis ou encore alliage de soudure, est ensuite réalisé sans problème particulier pour établir un bon contact électrique entre les épanouissements 7 des broches 2 et les parties métallisées ou électrodes 10 du diapason 8. L'absence de tout jeu à l'endroit du contact résoud le problème de la quantité de matière à apporter, tout risque d'excès ou d'insuffisance étant écarté. De même le contact mécanique entre les épanouissements 7 et le diapason 8 résoud le problème des échanges thermiques, ce qui permet la réalisation d'une bonne soudure.

Revendications :

1. Procédé de fixation d'un résonateur piézoélectrique à diapason sur une embase support traversée par deux broches conductrices en matériau déformable, caractérisé par le fait que l'on plie l'une vers l'autre les broches de manière que l'espace restant libre entre elles soit légèrement inférieur à l'épaisseur du diapason, que l'on insère entre les broches le diapason qui reste maintenu par pincement, et que l'on achève la fixation par dépôt d'une pâte ou vernis conducteur ou d'un alliage de soudure.

2. Procédé de fixation selon la revendication 1, caractérisé par le fait que, préalablement à l'insertion du diapason, l'on écrase la partie pliée de chaque broche pour former un épanouissement plan sur lequel le diapason va venir en appui par une de ses grandes faces.

3. Procédé de fixation selon la revendication 2, caractérisé par le fait que lors de l'écrasement de la partie pliée des broches on en écrase l'extrémité de manière que l'espace libre à ces extrémités soit très légèrement supérieur à l'épaisseur du diapason.

1/1

**Fig.1a.**

**Fig.1b.**

**Fig.2a.**

**Fig.2b.**

**Fig.3a.**

**Fig.3b.**

0028783

Office européen
des brevets

**RAPPORT DE RECHERCHE EUROPEENNE**

Numéro de la demande

EP 80 10 6731

| | DOCUMENTS CONSIDERES COMME PERTINENTS | | CLASSEMENT DE LA DEMANDE (Int. Cl. 3) |
|---|---|---|---|
| Catégorie | Citation du document avec indication, en cas de besoin, des parties pertinentes | Revendication concernée | |
| | CH - A - 600 679 (DAINA SEIKOSHA)<br>* Document en entier * | 1 | H 03 H 9/05 |
| | -- | | |
| | US - A - 3 340 410 (W.W. SANFORD)<br>* Document en entier * | 1,3 | |
| | -- | | |
| | FR - A - 2 417 886 (SOCIETE SUISSE POUR INDUSTRIE HORLOGERE MANAGEMENT SERVICES)<br>* Figures 1,2; page 2, ligne 23 - page 3, ligne 21 * | 1 | |
| | | | **DOMAINES TECHNIQUES RECHERCHES (Int. Cl. 3)** |
| | -- | | |
| | PATENTS ABSTRACTS OF JAPAN, vol. 1, no. 163, 22 décembre 1977, page 9081E77<br>& JP - A - 52 108789 (DAINI SEI-KOSHA K.K.) (09-12-1977)<br>* Document en entier * | 1 | H 03 H<br>G 04 F |
| | -- | | |
| | PATENTS ABSTRACTS OF JAPAN, vol. 2, no. 13, 28 janvier 1978, page 10626E77<br>& JP - A - 52 129395 (DAINI SEI-KOSHA K.K.)(29-10-1977)<br>* Document en entier * | 1 | |
| | | | **CATEGORIE DES DOCUMENTS CITES** |
| | -- | | X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons |
| | PATENTS ABSTRACTS OF JAPAN, vol. 2, no. 79, 23 juin 1978, page 3344E78<br>& JP - A - 53 45189 (DAINI SEI-KOSHA)( 22-04-1978)<br>* Document en entier * | 1 | |
| | ---- | | &: membre de la même famille, document correspondant |

√ Le présent rapport de recherche a été établi pour toutes les revendications

| Lieu de la recherche | Date d'achèvement de la recherche | Examinateur |
|---|---|---|
| La Haye | 04-01-1981 | COPPIETERS |

OEB Form 1503.1   06.78